(19) **Europäisches Patentamt**

**European Patent Office**

**Office européen des brevets**

(11) **EP 1 429 456 A1**

(12) **EUROPEAN PATENT APPLICATION**
published in accordance with Art. 158(3) EPC

(43) Date of publication:
**16.06.2004 Bulletin 2004/25**

(51) Int Cl.7: **H03G 3/10**, H03G 3/20

(21) Application number: **01967768.1**

(86) International application number:
**PCT/JP2001/008216**

(22) Date of filing: **20.09.2001**

(87) International publication number:
**WO 2003/028210 (03.04.2003 Gazette 2003/14)**

(84) Designated Contracting States:
**AT BE CH CY DE DK ES FI FR GB GR IE IT LI LU
MC NL PT SE TR**
Designated Extension States:
**AL LT LV MK RO SI**

(71) Applicant: **MITSUBISHI DENKI KABUSHIKI
KAISHA
Tokyo 100-8310 (JP)**

(72) Inventors:
• **TAKAHASHI, Y.
MITSUBISHI DENKI KABUSHIKI KAISHA
Chiyoda-ku, Tokyo100-8310 (JP)**

• **JOBA, Hiroyuki
MITSUBISHI DENKI KABUSHIKI KAISHA
Chiyoda-ku, Tokyo 100-8310 (JP)**
• **NAKAMIZO,Hideyuki
MITSUBISHI DENKI KABUSHIKIKAISHA
Chiyoda-ku, Tokyo 100-8310 (JP)**

(74) Representative: **Sajda, Wolf E., Dipl.-Phys. et al
MEISSNER, BOLTE & PARTNER
Postfach 86 06 24
81633 München (DE)**

(54) **VARIABLE GAIN AMPLIFIER OF LOW POWER CONSUMPTION**

(57)     In a differential pair control type variable gain amplifier, amount of driving current of a current source (30; 30b-30n) is adjusted in accordance with the gain thereof. Specifically, in accordance with a control voltage (VCR) generated by a variable voltage source (25) determining the gain of a differential stage (20, 21) generating an output signal in accordance with an input signal, the amount of driving current of a current source transistor (Q2) of the differential stage is adjusted to be smaller as the gain becomes lower. Only the current in accordance with the gain is consumed, and the current consumption is reduced without causing signal distortion.

FIG. 7

## Description

<u>Technical Field</u>

The present invention relates to a variable gain amplifier and, more specifically, to a configuration of a variable gain amplifier used for controlling transmission power in a wireless communication apparatus.

<u>Background Art</u>

A variable gain amplifier (VGA: Variable Gain Amplifier) has been used for various applications, as it is possible to vary the gain thereof. In a wireless communication apparatus, for example, it is necessary to control transmission power in accordance with the environment of use. Therefore, a variable gain amplifier is used for adjusting power of such transmission signals.

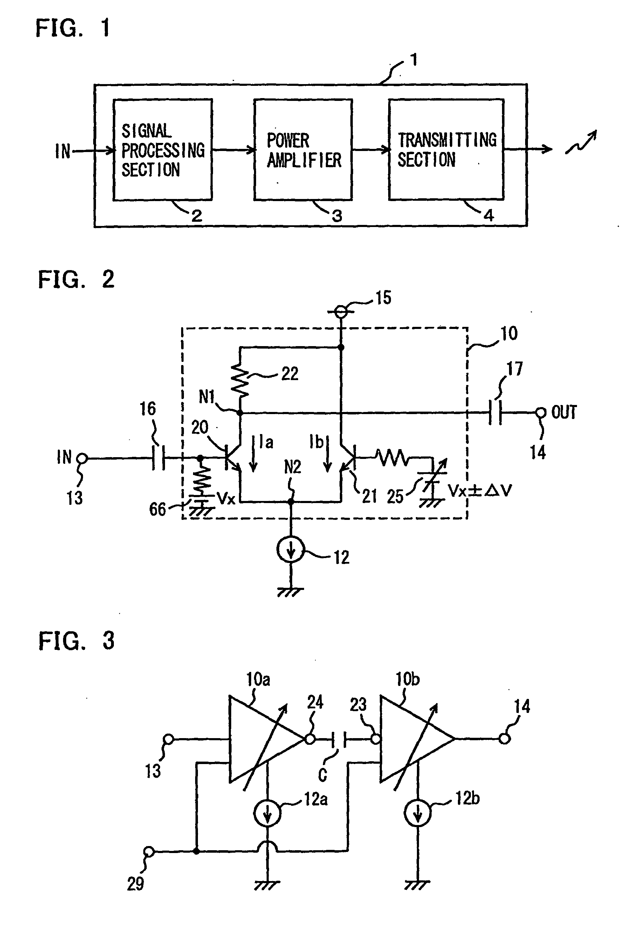

Fig. 1 schematically shows a configuration of a transmission system of a general wireless communication apparatus. Referring to Fig. 1, a wireless communication apparatus 1 includes a signal processing section 2 performing a prescribed processing on an input signal IN such as an audio signal or a video signal, a power amplifier 3 amplifying the signal generated by the signal processing section 2, and a transmitting section 4 generating a transmission signal in accordance with the signal from power amplifier 3 and transmitting the signal through an antenna, not shown.

The signal processing section generates the transmission signal by performing a prescribed encoding process, for example, on the input signal. Power amplifier 3 amplifies power of the signal to be transmitted, in order to transmit the signal from wireless communication apparatus 1 through the antenna (not shown).

Transmitting section 4 includes a transmission control circuit, and transmits signals through the antenna, in accordance with the transmission signal from power amplifier 3.

In such wireless communication apparatus 1 as shown in Fig. 1, it is necessary to adjust transmission power in accordance with the condition of transmission. In order to realize such control of transmission power, a variable gain amplifier is used as power amplifier 3, and transmission power is controlled by power amplifier 3. There are two types of configurations of such variable gain amplifier, that is, differential pair control type and current source control type. In the current source control type amplifier, the current flowing through the entire circuit of the variable gain amplifier is controlled, so that the gain is controlled. In the differential pair control type, voltage level applied to a control node (base) of a reference transistor constituting the differential pair is adjusted, so that amount of change in output current that is generated in accordance with the input signal is adjusted, and hence the gain is controlled.

Fig. 2 shows an example of the configuration of a conventional differential pair control type variable gain amplifier. Referring to Fig. 2, the variable gain amplifier includes a gain control section 10 of which gain is variable, for amplifying a signal applied to a signal input terminal 13 and transmitting the result to a signal output terminal 14, and a constant current source 12 determining operating current of variable gain control section 10. The signal applied to signal input terminal 13 is applied through a capacitance element 16 for cutting off DC component, to variable gain control section 10. The signal output from gain control section 10 is transmitted through capacitance element 17 for cutting off DC component, to signal output terminal 14.

The ratio between amplitudes of the signal OUT appearing at signal output terminal 14 and an input signal IN applied to signal input terminal 13 is adjusted by gain control section 10. The variable gain control section 10 includes a resistance element 22 connected between a power supply node 15 and a node N1, an NPN bipolar transistor 20 connected between nodes N1 and N2 and receiving at its base the input signal IN through capacitance element 16, and an NPN bipolar transistor 21 connected between power supply node 15 and node N2 and receiving at its base an output voltage of a variable voltage source 25.

Bipolar transistor 20 has its base connected to a voltage source 66 through a resistance element. To bipolar transistors 20 and 21, resistance elements for generating a base current are connected. Voltage source 66 supplies a voltage Vx, and variable voltage source 25 supplies a voltage $Vx \pm \Delta V$.

From node N1 through capacitance element 17 to output terminal 14, an output signal of variable gain control section 10 is output. Transistors 20 and 21 form a differential stage, each causing current flow in accordance with the difference between the output voltage of voltage source 66 and the output voltage of variable voltage source 25. By resistance element 22, a voltage signal is generated at node N1, in accordance with a driving current (collector current) of transistor 20, and the signal is transmitted through capacitance element 17 to signal output terminal 14.

Constant current source 12 causes a constant current to flow from node N2 to the ground node. The driving current of constant current source 12 is equal to the sum of currents Ia and Ib flowing through bipolar transistors 20 and 21. The voltage level of the signal appearing at node N1 is represented as VCC-Ia•R22. Here, Vcc represents a power supply voltage, and R22 represents resistance value of resistance element 22. Current Ia changes in accordance with the difference between the output voltage of variable voltage source 25 and the sum of the voltage of the input signal and the output voltage of voltage source 66. When the voltage level of the input signal is higher than the output voltage of variable voltage source 25 and the voltage difference is large, driving current Ia of bipolar transistor 20 becomes larger. Therefore, by adjusting the output voltage of variable voltage source 25, the driving current (collector current) Ia of bipolar transistor 22 can be adjusted and hence amplitude of the signal appearing at node N1 can be adjusted. Thus, the gain of output signal OUT with respect to the input signal IN can be adjusted.

Specifically, in the differential pair control type variable gain amplifier as shown in Fig. 2, the ratio of power amplification depends on the collector current Ia flowing through bipolar transistor 20, which receives at its base the input signal. The collector current Ia can be changed by the voltage of variable voltage source 25. Specifically, when the amplitude of input signal IN is the same and the output voltage of variable voltage source 25 is made higher, the base voltage of bipolar transistor 21 becomes higher, the collector current Ib becomes larger, and hence, the collector current Ia of bipolar transistor 20 can be made relatively smaller. In contrast, when the output voltage level of variable voltage source 25 is decreased, the collector current Ib of bipolar transistor 21 becomes smaller, and the collector current Ia of bipolar transistor 20 can be made larger. Therefore, in the differential pair control type variable gain amplifier, the ratio of power amplification (gain) can be controlled by the output voltage of variable voltage source 25.

Here, when the input signal IN applied to the base of the bipolar transistor is at the high voltage level, the collector current Ia driven by bipolar transistor 20 increases, the amount of voltage drop at node N1 increases accordingly, and the output signal OUT attains to the lower voltage level. In contrast, when the input signal IN is at the low voltage level, collector current of bipolar transistor 20 decreases, the amount of voltage drop at node N1 reduces, and the voltage level of node N1 attains to the high level. Therefore, the variable gain control section 10 inverts the input signal IN and outputs the result.

The input signal IN is biased to a voltage level higher than the voltage generated by variable voltage source 25, with the output voltage of voltage source 66. In accordance with the difference between the voltage level of input signal IN and output voltage of variable voltage source 25, the driving current of bipolar transistor 20 is determined. Therefore, when the output voltage of variable voltage source 25 is set higher than the output voltage Vx of voltage source 66, the difference between the output voltage of variable voltage source 25 (Vx+$\Delta$V) and the sum of input signal IN and the output voltage of voltage source 6 becomes smaller, the amount of driving current of bipolar transistor 20 becomes smaller, signal amplitude at node N1 becomes smaller, and the gain is reduced. On the other hand, when the output voltage of variable voltage source 25 is made lower, the difference between the output voltage of variable voltage source 25 (Vx-$\Delta$V) and the sum of input signal IN and voltage source 66 becomes larger, driving current of bipolar transistor 20 becomes larger, signal amplitude at node N1 increases and the gain increases.

In such a variable amplifier, when the gain of the variable gain control section of one stage is too small to sufficiently amplify the signal, a plurality of stages of variable gain control sections 10 are cascade-connected to form an amplifier.

Fig. 3 schematically shows a configuration of the variable gain amplifier having two stages. Referring to Fig. 3, the variable gain amplifier includes cascade-connected variable gain control sections 10a and 10b, and constant current sources 12a and 12b determining driving currents of variable gain control sections 10a and 10b, respectively. A signal input node 13a is coupled to gain control section 10a of the first stage, and gain control section 10b of the output stage is coupled to a signal output node 14a. These nodes 13a and 14a are coupled through capacitance elements for cutting off DC component, to signal input terminal 13 and signal output terminal 14. An output of variable gain control section 10a is coupled to an input of variable gain control section 10b through a capacitance element C for removing DC component.

These variable gain control sections 10a and 10b have the same configuration as variable gain control section 10 shown in Fig. 2. The variable voltage source included in each of the variable gain control sections 10a and 10b has its output voltage level adjusted by a signal applied to a control terminal 29.

In the variable gain amplifier having the configuration of two stages shown in Fig. 3, the variable gain control section 10a of the first stage amplifies a signal applied to signal input node 13a, and transmits the amplified signal to an internal output node 24. The variable gain control section 10b of the next stage receives the signal generated at output node 24 of variable gain control section 10a at input node 23, amplifies the signal, and outputs the amplified signal from signal output node 14a.

The gains of variable gain control section 10a and 10b are adjusted in accordance with the signal from control terminal 29, whereby even when the gain G at individual variable gain control section 10a or 10b is small, the gain of the signal appearing at signal output node 14a would be G · G, and hence a signal with sufficiently large gain can be generated.

In the differential pair control type variable gain amplifier having the multistage configuration, it is necessary in the variable gain amplifier of each stage (10a, 10b) that large distortion in the output signal should not be generated even when the gain is maximized. Therefore, in each stage of the variable gain control section, the current necessary for an operation with maximum gain is constantly driven by the corresponding constant current source (12a, 12b).

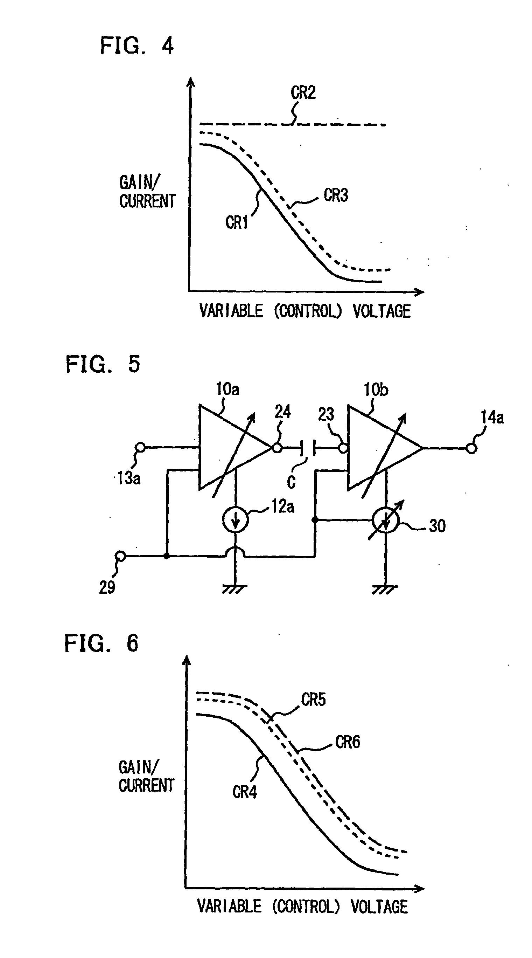

Fig. 4 represents relation between the gain of the variable gain control section, the current and the control voltage (output voltage of variable voltage source) in the differential pair control type variable gain amplifier. Referring to Fig. 4, the abscissa represents the output voltage (control voltage) of the variable voltage source, and the ordinates represents the gain and current flowing through the circuit. The curve CR1 represents the gain at the variable gain control section, the straight line CR2 represents current flowing through the circuit, that is, the driving current of the constant current source, and the curve CR3 represents current necessary for generating the output signal without generating large distortion in the signal, that is, generating an output signal while maintaining linearity of the signal.

As shown in Fig. 4, when the gain is small, the output signal has small amplitude, and therefore, the necessary current is small. When the gain is large, the output signal comes to have a large amplitude, and therefore, the necessary amount of current increases. Therefore, the amount of current necessary for generating an output signal while maintaining linearity depends on the gain.

In the differential pair control type variable gain amplifier, however, even when the gain is small and the necessary amount of current is small, the currents same in magnitude as the current necessary for the maximum output signal level (maximum gain) is driven by the constant current source. Therefore, in an operation with low gain, unnecessary current is consumed. In a portable terminal equipment having communication function, a battery is used as a power source. In view of battery life time, power consumption as low as possible is desirable.

Disclosure of the Invention

An object of the present invention is to provide a differential pair control type variable gain amplifier with low power consumption.

Another object of the present invention is to provide a differential pair control type variable gain amplifier having multistage configuration with low power consumption.

The variable gain amplifier in accordance with the present invention includes a differential stage of which gain is adjustable, and a current source that determines the current flowing through the differential stage. The amount of current driven by the current source is adjusted in accordance with the gain of the differential stage.

Preferably, the differential stage and a current source are arranged at a variable gain control section of the second or the following stages, in the variable gain amplifier having multistage configuration.

As the amount of current driven by the current source is adjusted in accordance with the gain, it becomes possible to supply optimal current in accordance with the gain, and the current consumption can be reduced without impairing linearity of the output signal. Thus, it becomes unnecessary to constantly supply the current that corresponds to the maximum gain, and power consumption can be reduced.

In the variable gain amplifier having multistage configuration, the amount of driving current at the variable gain control sections of the second and the following stages are adjusted in accordance with the gain, and therefore, the driving current in the second and the following differential stages, in which signal amplitude is larger for the same gain and consumes larger current as compared with the variable gain control section of the first stage, can be reduced, and hence power consumption can surely be reduced.

The foregoing and other objects, features, aspects and advantages of the present invention will become more apparent from the following detailed description of the present invention when taken in conjunction with the accompanying drawings.

Brief Description of the Drawings

Fig. 1 schematically shows a configuration of a transmission system in a wireless communication apparatus.
Fig. 2 shows an example of a circuit schematic of a conventional differential pair control type variable gain amplifier.
Fig. 3 schematically shows a configuration of a conventional differential pair control type variable gain amplifier with multistage configuration.
Fig. 4 represents relation between gain, circuit operating current and control voltage in a conventional variable gain amplifier.
Fig. 5 schematically shows a configuration of a variable gain amplifier in accordance with a first embodiment of the present invention.
Fig. 6 represents relation between gain and driving current of a variable gain amplifier in accordance with the first embodiment of the present invention.
Fig. 7 shows an example of the configuration of variable gain control section and variable current source of the second stage of the variable gain control section shown in Fig. 6.
Fig. 8 shows an example of the configuration of variable voltage source shown in Fig. 7.
Fig. 9 shows another example of the configuration of variable voltage source shown in Fig. 7.
Fig. 10 shows an example of the configuration of control voltage generating circuit shown in Fig. 7.
Fig. 11 shows another example of the configuration of control voltage generating circuit shown in Fig. 7.
Fig. 12 shows a configuration of a variable gain amplifying stage in accordance with a second embodiment of the present invention.
Fig. 13 schematically shows a configuration of a variable gain amplifier in accordance with a third embodiment of the present invention.
Fig. 14 shows a configuration of the second and following amplifying stages of the variable gain amplifier shown in Fig. 13.

Fig. 15 schematically shows a configuration of a modification of the variable gain amplifier in accordance with the third embodiment of the present invention.

Best Modes for Carrying Out the Invention

[First Embodiment]

Fig. 5 schematically shows a configuration of a differential pair control type variable gain amplifier in accordance with the first embodiment of the present invention. Referring to Fig. 5, the variable gain amplifier includes a variable gain control section 10a amplifying a signal at an input node 13a, a variable gain control section 10b further amplifying an output signal from variable gain control section 10a, a capacitance element C for removing a DC coupling between the output of variable gain control section 10a and the input of variable gain control section 10b, a constant current source 12a provided for variable gain control section 10a and determining operating current of variable gain control section 10a, and a variable current source 30 provided for variable control section 10b, and having the amount of driving current adjusted in accordance with the gain of variable gain control section 10b. Operating current of variable gain control section 10b is determined by variable current source 30. Here, "operating current" represents sum of currents flowing through the transistors of the differential stages.

Variable gain control sections 10a and 10b have their gain adjusted in accordance with a control signal applied to a control terminal 29, and the amount of driving current of variable current source 30 is also determined in accordance with the control signal applied to control terminal 29. For variable gain control section 10b, an amount of current considered necessary in correspondence with the value of each gain is calculated in advance. Specifically, in the configuration of variable gain control section 10b, when transistor parameters are determined, it is possible to calculate the amount of driving current of the transistor at the signal input portion and the driving current of the transistor receiving at its base the control voltage (output voltage of variable voltage source). In accordance with the result of calculation, the gain of variable gain control section 10b and the amount of driving current of variable current source 30 are commonly adjusted, by the control signal applied to control terminal 29.

Variable gain control sections 10a and 10b have the same architecture as variable gain control section 10 shown in Fig. 2, and by differential transistors 20 and 21, amplifies and outputs an applied signal.

In the variable gain control section 10b of the second stage, the variable current source 30 is controlled, in correspondence with the change in the gain. In accordance with the gain of variable gain control section 10b, the amount of driving current of variable current source 30 is adjusted such that only such an amount of current is driven that is necessary to prevent generation of large distortion in the output signal and to maintain linearity of the input/output signal. When the gain becomes smaller at variable gain control section 10b, the amount of driving current of variable current source 30 is set to the minimum necessary current amount, and thus, an excess current flow at variable gain control section 10b is prevented.

Input node 13a is coupled to signal input terminal 13 shown in Fig. 2 through a DC cut-off capacitance element 16, and output node 14a is coupled to signal output terminal 14 through a DC cut-off capacitance element 17 shown in Fig. 2.

In the variable amplifier having two-stage configuration, though gain of each of variable gain control section 10a and 10b is small, the gain of the final output signal is made large, by multiplying the gains. Therefore, in variable gain control section 10b of the second stage generating the final output signal, it is necessary to ensure large signal amplitude. Therefore, in order to maintain linearity of the output signal, a large current amount is necessary, as compared with the variable gain control section 10a of the first stage. By adjusting the operating current (driving current of variable current source 30) in accordance with the gain at variable gain control section 10b generating the final output signal, the current that has been set in accordance with the maximum gain can significantly be reduced, and the current consumption can further be reduced.

Fig. 6 represents relation between gain, operating current and control voltage (corresponding to the output voltage of variable voltage source 25) of variable gain control section 10b shown in Fig. 5. Referring to Fig. 6, the ordinate represents gain and operating current, and the abscissa represents control voltage. The curve CR4 represents gain of gain control section 10b, the curve CR5 represents operating current amount necessary for maintaining signal linearity in accordance with the gain, and curve CR6 represents the amount of driving current of variable current source 30.

As shown in Fig. 6, by adjusting the amount of driving current of variable current source 30 in accordance with the current necessary for each gain, only the minimum necessary current comes to be consumed by the variable gain control section 10b, and it becomes unnecessary to supply the current set in accordance with the maximum gain regardless of the value of the gain. Thus, current consumption can be reduced.

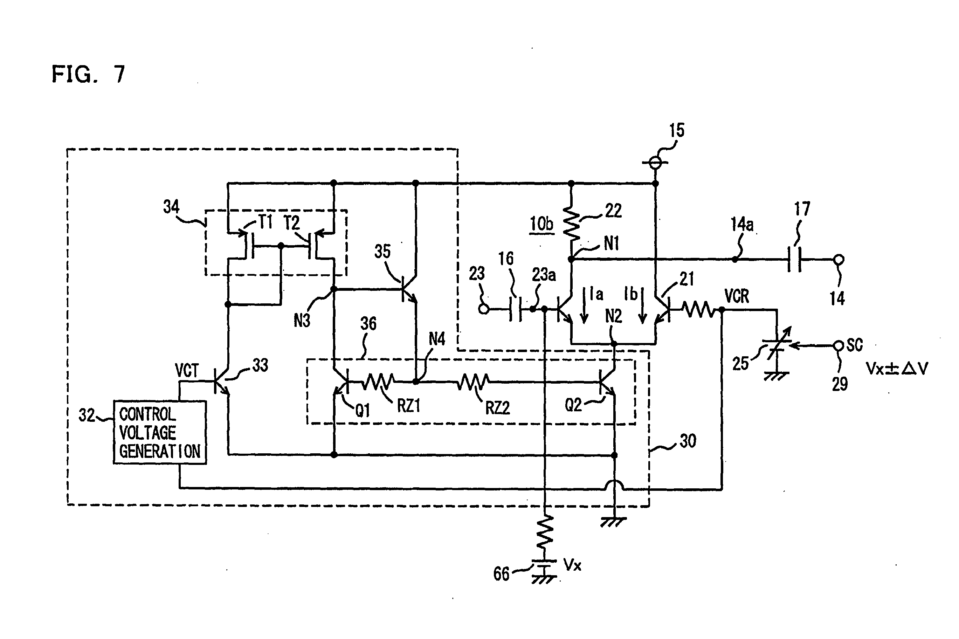

Fig. 7 shows an example of the configuration of variable gain control section 10b and variable current source 30 shown in Fig. 5. Referring to Fig. 7, variable gain control section 10b includes, as in the prior art, a resistance element 22 connected between power supply node 15 and node N1, an NPN bipolar transistor 20 connected between nodes N1 and N2 and having its base connected to input node 23a, an NPN bipolar transistor 21 connected between power supply node 15 and node N2 and receiving at its base a variable voltage VCR, and a variable voltage source 25 generating the variable control voltage VCR in accordance with a control signal SC applied to control terminal 29.

Variable voltage source 25 is coupled to the base of bipolar transistor 21 through a resistance element. A voltage source 66 is coupled to node 23a through a resistance element.

Node N1 is connected to a node 14a. An input node 23a is connected to signal input node 23 through a DC cut-off capacitance element 16. Output node 14a is connected to signal output terminal 14 through a DC cut-off capacitance element 17.

The configuration of variable gain control section 10b shown in Fig. 7 is the same as the prior art, and in accordance with the control voltage VCR output by variable voltage source 25 and the voltage at input node 23a, the currents Ia and Ib flowing through NPN bipolar transistors 20 and 21 vary, respectively. The voltage at input node 23a is given as a sum of the output voltage of voltage source 66 and the signal applied from signal input node 23 through capacitance element 16 to input node 23a. When the signal voltage at input node 23a is biased to a voltage level higher than the control voltage VCR, that is, when the output voltage of voltage source 66 is higher than the output voltage of variable voltage source 25, the collector current Ia of bipolar transistor becomes larger than the collector current Ib of bipolar transistor 21. In this state, when control voltage VCR becomes higher, the difference between the input signal and control voltage VCR becomes smaller, the current Ia flowing through bipolar transistor 20 becomes smaller, and gain of variable gain control section 10b becomes smaller. On the other hand, when control voltage VCR becomes lower, the difference between the input signal and control voltage VCR becomes larger, the current Ia flowing through bipolar transistor 20 increases, and the gain of variable gain control section 10b increases. The sum of these collector currents Ia and Ib is determined by the driving current of variable current source 30.

Variable current source 30 includes an NPN bipolar transistor Q2 coupled between node N2 and ground node, a control voltage generating circuit 32 generating a voltage that is in inverse proportion to control voltage VCR, an NPN bipolar transistor 33 driving the current in accordance with the voltage VCT generated by control voltage generating circuit 32, and a current mirror circuit 34 supplying the driving current to bipolar transistor 33.

Current mirror circuit 34 includes a P channel MOS transistor (insulated gate type filed effect transistor) T1 supplying current to bipolar transistor 33, and a P channel MOS transistor T2 connected between power supply node 15 and node N3 and having its gate connected to the gate of MOS transistor T1. MOS transistor T1 has its gate and drain connected to the collector of bipolar transistor 33. Therefore, in current mirror circuit 34, MOS transistor T1 provides a master stage, and the current same in magnitude as the current flowing through MOS transistor T1 flows through MOS transistor T2 (provided that MOS transistors T1 and T2 are of the same size). More specifically, through MOS transistor T2, a mirror current of collector current of bipolar transistor 33 flows to node N3.

Variable current source 30 further includes an NPN bipolar transistor 35 supplying the collector current from power supply node 15 to node N4 in accordance with the voltage of node N3, an NPN bipolar transistor Q1 coupled between node N3 and a ground node and has its base coupled to node N4 through resistance element RZ1, and an NPN bipolar transistor Q2 coupled between node N2 and a ground node and having its base coupled to node N4 through resistance element RZ2. Bipolar transistor Q2 functions as a current source transistor for differential stage transistors 20 and 21.

Resistance elements RZ1 and RZ2 satisfy the following relation, where Q1 and Q2 represent sizes (emitter areas) of bipolar transistors Q1 and Q2.

$$Q1 : Q2 = 1/RZ1 : 1/RZ2$$

Here, RZ1 and RZ2 represent resistance values of resistance elements RZ1 and RZ2.

Accordingly, when bipolar transistors Q1 and Q2 are of the same size, resistance elements R1 and R2 have the same resistance value. Bipolar transistors Q1 and Q2 have their emitters commonly coupled, and the bipolar transistors Q1 and Q2 form a current mirror circuit (as the base-emitter voltage becomes the same). Therefore, the operating current for differential stage transistors 20 and 21 is determined by the mirror current of the driving current (collector current) of bipolar transistor 33.

Control voltage generating circuit 32 generates a voltage that changes in inverse proportion to control voltage VCR output from variable voltage source 25. Specifically, the control voltage VCT generated by control voltage generating circuit 32 changes reciprocally with respect to control voltage VCR. Namely, when control voltage VCR output from variable voltage source 25 increases, the voltage level of control voltage VCT generated by control voltage generating circuit 32 decreases. When the voltage level of control voltage VCT output from control voltage generating circuit 32 lowers, the base-emitter voltage of bipolar transistor 33 becomes smaller, and the collector current of bipolar transistor 33 decreases. Accordingly, the current supplied by current mirror circuit 34 to node N3 decreases. The current supplied to node N3 is used as the collector current of bipolar transistor Q1.

When the base voltage of bipolar transistor Q1 increases so that bipolar transistor Q1 can discharge all the current supplied from current mirror 34 and the voltage level of node N3 decreases, then base-emitter voltage of bipolar transistor 35 decreases, lowering the base voltage of bipolar transistor Q1. At this time, bipolar transistor 35 has its emitter current decreased, and accordingly, the base current supplied to bipolar transistor Q1 through resistance element RZ1 decreases. Consequently, the collector current of bipolar transistor Q1 decreases, and collector current of bipolar transistor Q2 decreases accordingly.

On the contrary, when base voltage of bipolar transistor Q1 is so low that the current supplied by MOS transistor T2 of current mirror circuit 34 cannot fully be discharged and the voltage level of node N3 increases, the base-emitter voltage of bipolar transistor 35 increases and, accordingly, the voltage level of node N3 increases. At this time, the emitter current of bipolar transistor 35 increases and accordingly, the base current of bipolar transistor 36 increases, whereby the collector current of bipolar transistor 36 increases. Thus, the voltage level of node N3 decreases.

Bipolar transistor 35 functions as an emitter follower transistor of which base-emitter voltage is always constant, that is, it adjusts the voltage level of node N4 in accordance with the voltage level of node N3 and, accordingly, adjusts collector current of bipolar transistor Q1.

Therefore, by the negative feedback of bipolar transistor 35, a collector current same in magnitude as the current supplied by MOS transistor T2 of current mirror circuit 34 constantly flows through bipolar transistor Q1. Resistance elements R1 and R2 are shunt resistances of the emitter current of bipolar transistor 35, supply base current of the same magnitude to bipolar transistors Q1 and Q2, and bias the bases of these bipolar transistors Q1 and Q2 to the same voltage level. Further, bipolar transistors Q1 and Q2 come to have the same base-emitter voltage, and thus, the bipolar transistors Q1 and Q2 form a current mirror circuit 36.

Bipolar transistor Q2 is a current source transistor of differential stage transistors 20 and 21. Therefore, operating current (current Ia+Ib) of variable gain control section 10b can be adjusted in accordance with the control voltage VCR of variable voltage source 25. When the control voltage VCR increases, the voltage level of control voltage VCT generated by control voltage generating circuit 32 decreases, the collector current of bipolar transistor 33 decreases and, in response, the collector current driven by current source transistor Q2 decreases. In contrast, when the control voltage VCR generated by variable voltage source 25 decreases, the voltage level of control voltage VCT generated by control voltage generating circuit 32 increases, and by the current mirror circuits 34 and 36, the collector current of current source bipolar transistor Q2 is increased.

Therefore, as shown in Fig. 6, when control voltage VCR increases and the gain of variable gain control section 10b becomes smaller, the collector current of current source bipolar transistor Q2 decreases and when, on the other hand, the voltage level of control voltage VCR generated by variable voltage source 25 decreases and the gain G becomes larger, the collector current driven by current source bipolar transistor Q2 increases. Therefore, it is possible to adjust operating current of the variable amplifying stage in accordance with the gain, and therefore, only the necessary amount of current for maintaining signal linearity can be supplied constantly. Thus the current consumption can be reduced.

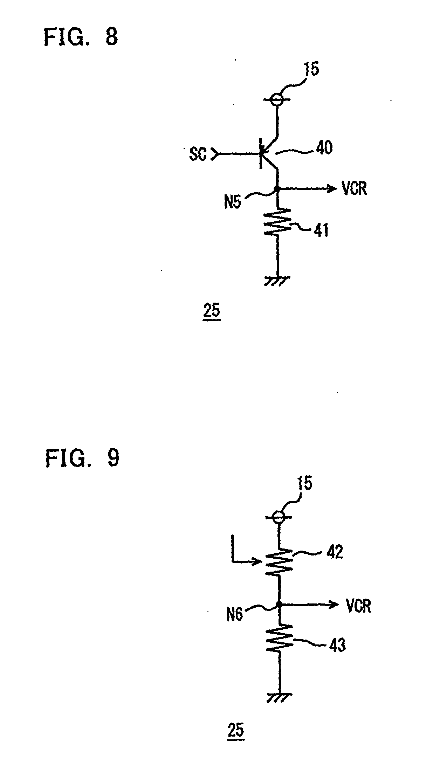

Fig. 8 shows an example of the configuration of variable voltage source 25 shown in Fig. 7. Referring to Fig. 8, variable voltage source 25 includes a PNP bipolar transistor 40 connected between power supply node 15 and node N5 and receiving at its base control signal SC, and a resistance element 41 connected between node N5 and ground node. At node N5, control voltage VCR is generated.

In the configuration of variable voltage source 25 shown in Fig. 8, when control signal SC attains to the high level, the base-emitter voltage of bipolar transistor 40 becomes smaller, the collector current of bipolar transistor 40 decreases, the amount of voltage drop at resistance element 41 becomes smaller, and the voltage level of control voltage VCR decreases. On the other hand, when the voltage level of control signal SC decreases, base-emitter voltage of bipolar transistor 40 increases, the collector current supplied by bipolar transistor 40 becomes large, the amount of voltage drop at resistance element 41 increases, and the voltage level of control voltage VCR increases.

Specifically, when the gain G is to be made higher, the voltage level of control signal SC is increased so that the amount of voltage drop across resistance element 41 is reduced and the voltage level of control voltage VCR is decreased. By adjusting the voltage level of control signal SC in accordance with the gain G, it becomes possible to set the control voltage VCR to a voltage level that enables the target gain.

Fig. 9 schematically shows another configuration of variable voltage source 25 shown in Fig. 7. Referring to Fig. 9, variable voltage source 25 includes a variable resistance element 42 connected between power supply node 15 and node N6, and a resistance element 43 connected between node N6 and the ground node. At node N6, control voltage VCR is generated.

Variable resistance element 42 is provided, for example, by a sliding resistance, and resistance value thereof is variable. Therefore, by adjusting the resistance value of variable resistance element 42, it is possible to adjust the voltage level of control voltage VCR from node N6. When resistance value of variable resistance element 42 becomes smaller, voltage level of control voltage VCR increases, and when resistance value of variable resistance element 42 becomes larger, the voltage level of control voltage VCR decreases. As variable voltage source 25, configurations shown in Figs. 8 and 9 may be combined. Specifically, a configuration may be used in which the control signal SC is generated by the valuable resistance element shown in Fig. 9, and the signal is applied to the base of bipolar transistor 40 shown in Fig. 8.

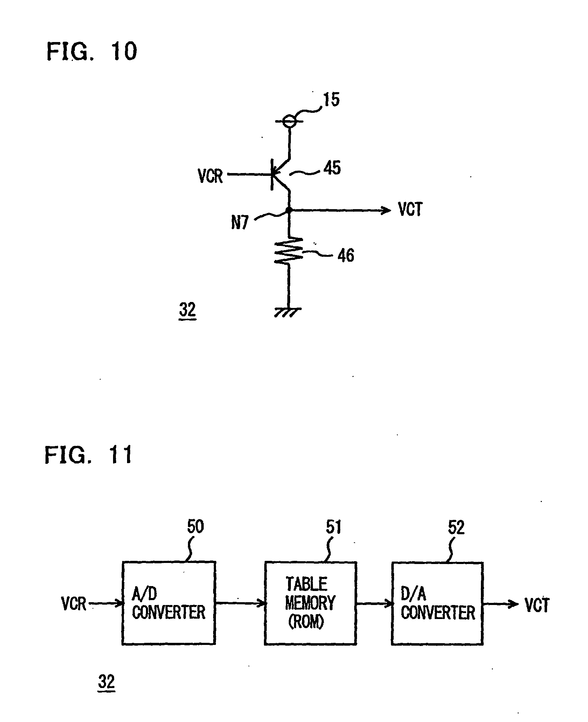

Fig. 10 shows an example of the configuration of control voltage generating circuit 32 shown in Fig. 7. Control voltage generating circuit 32 shown in Fig. 10 includes a PNP bipolar transistor connected between power supply node 15 and node N7, and receiving at its base control voltage VCR, and a resistance element 46 connected between node N7 and ground node. At node N7, control voltage VCT is generated.

In the configuration shown in Fig. 10, when voltage level of control voltage VCR increases, collector current supplied by bipolar transistor 45 is reduced, the amount of voltage drop across resistance element 46 becomes smaller accordingly, and the voltage level of node N7 decreases. When the voltage level of control voltage VCR decreases, collector current supplied by bipolar transistor 45 increases, the amount of voltage drop across resistance element 46 becomes larger, and the voltage level of control voltage VCT at node N7 increases. Accordingly, when control voltage VCR increases and gain G becomes smaller, the voltage level of control voltage VCT lowers, and reduces the driving current of current source transistor Q2.

On the other hand, when control voltage VCR lowers and gain G is to be enlarged, collector current of bipolar transistor 45 increases and the control voltage VCT increases. As the voltage level of control voltage VCT increases, collector current of current source transistor Q2 increases, and operating current of variable gain control section 10b increases.

Referring to Fig. 10, by appropriately adjusting the resistance value of resistance element 46 and the collector current driven by bipolar transistor 45, control voltage VCT can be generated such that minimum necessary current can be supplied in accordance with the gain G, in accordance with the correspondence between control voltages VCR and VCT.

Fig. 11 schematically shows another configuration of control voltage generating circuit 32 shown in Fig. 7. Referring to Fig. 11, control voltage generating circuit 32 includes an analog/digital converter (A/D converter) 50 converting the control voltage VCR to a digital signal, a table memory 51 of which contents are read using an output signal from A/D converter 50 as an address, and a digital/analog converter (D/A converter) 52 converting a signal read from table memory 51 to an analog signal. From D/A converter 52, control voltage VCT is generated.

Table memory 51 is provided, for example, by an ROM (Read Only Memory), and stores, in the form of a table, a list representing relation between control voltages VCR and VCT. Therefore, by reading a corresponding data from the table memory 51 in accordance with the voltage level of control voltage VCR, the control voltage VCT for adjusting operating current of the gain control section can be generated exactly.

In the configuration shown in Fig. 11, A/D converter 50, D/A converter 52 and table memory 51 are necessary. In a portable terminal equipment having communicating function, however, a signal processing apparatus for coding transmitting signals at the time of transmission is provided, in which signal processing section, a memory, an A/D converter and a D/A converter are provided. Therefore, the control voltage conversion may be performed at the signal processing section.

As described above, according to the first embodiment of the present invention, the differential pair control type variable amplifier is configured such that operating current of the differential stage is changed in accordance with the control voltage adjusting the gain thereof, so that only a minimum necessary current is consumed, and current consumption can be reduced without impairing linearity of the signal. Particularly in the application to battery-driven portable terminal equipment, current consumption can significantly be reduced, enabling longer battery life time.

Particularly, in a variable amplifier having multistage configuration where the signal amplitude is large even when the gain of the second and the following stages is small, the driving current is minimized, and therefore, current consumption can considerably be reduced (as the amplitude of the output signal of the amplifiers of the second and following stages becomes larger than the amplitude of the output signal from the differential stage of the input stage).

Here, the gain is set smaller when the control voltage VCR is made higher. Conversely, a differential stage control type variable gain amplifier of such a configuration in that the gain is made larger when the control voltage VCR is set higher may be used. In that case, control of the driving current is performed in the direction reverse to that described above, whereby optimal operating current can be supplied in accordance with the gain.

[Second Embodiment]

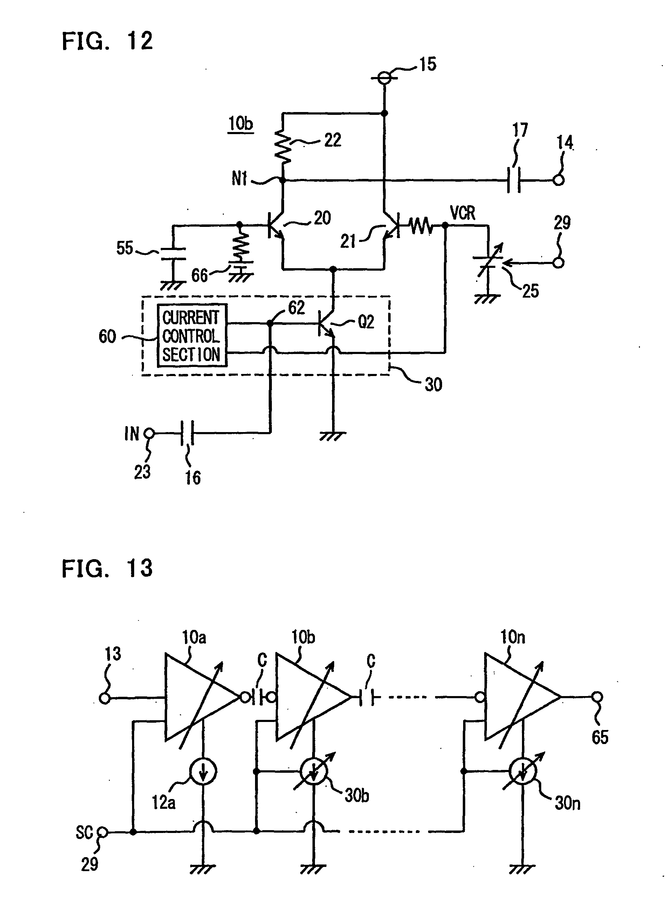

Fig. 12 shows a configuration of a variable gain amplifier in accordance with the second embodiment of the present invention. Fig. 12 shows a configuration of an output stage of a variable gain amplifier having multistage configuration. In the configuration shown in Fig. 12, in the variable current source 30 for gain control section 10b, a signal from input node 23 is applied through DC cut-off capacitance element 16, to a base node 62 of current source transistor Q2. Base node 62 of current source transistor Q2 is coupled to a current control section 60. Current control section 60 controls base voltage of current source transistor Q2 in accordance with the control voltage VCR generated by variable voltage source 25, and adjusts, in accordance with the gain G of variable gain control section 10b, the base current of current source transistor Q2. Current control section 60 corresponds to an architecture including control voltage generating circuit 32, bipolar transistor 33, current mirror circuit 34 and bipolar transistor Q1, shown in Fig. 7.

To the base node 62 of current source transistor Q2, an input signal IN is further applied through DC cut-off capacitance element 16. In gain control section 10b, the base of bipolar transistor 20 that has conventionally received the input signal is coupled through a resistance element to voltage source 66, and coupled to the ground node through a capacitance element 55. The base node of bipolar transistor 20 is biased by voltage source 66.

The voltage at base node 62 of bipolar transistor Q2 comes to have a voltage level corresponding to the base voltage generated by current control section 60 and input signal IN superposed, the amount of driving current of current source transistor Q2 further changes in accordance with the input signal IN, and the current source bipolar transistor Q2 amplifies the input signal IN.

As the collector current of bipolar transistor Q2 changes, collector current of bipolar transistor 20 also changes and, accordingly, the voltage level of node N1 also changes. In this amplifying operation, current control section 60 adjusts the amount of driving current of bipolar transistor Q2 in a direction opposite to the change in control voltage VCR generated by variable voltage source 25.

In the configuration shown in Fig. 12, base node 62 is coupled to node N4 shown in Fig. 7, through a resistance element. Therefore, the influence of the input signal IN on the current mirror operation of current mirror circuits 34 and 36 shown in Fig. 7 is suppressed. In current control section 60, the amount of driving current of bipolar transistor Q2 can be adjusted exactly in accordance with the control voltage VCR generated by variable voltage source 25, free from the influence of input signal IN.

As described above, according to the second embodiment of the present invention, an input signal is applied to the base of the current source transistor of the differential stage, and the current source transistor has the function of amplifying the input signal. Further, the amount of driving current of the current source transistor is adjusted in accordance with the gain. Thus, only a minimum necessary current is consumed, while amplifying operation is performed and output signal can be generated with the linearity of the input signal IN maintained.

[Third Embodiment]

Fig. 13 schematically shows a configuration of the differential pair control type variable gain amplifier in accordance with the third embodiment of the present invention. Referring to Fig. 13, the differential pair control type variable gain amplifier includes a cascade-connected plurality of stages of variable gain control sections 10a-10n, a constant current source 12a provided for variable gain control section 10a of the first stage, and variable current sources 30b-30n arranged corresponding to gain control sections 10b-10n, respectively. Input portions of variable gain control sections 10b-10n are respectively coupled to output portions of variable gain control sections of the preceding stage, through capacitance element C for cutting-off DC.

To variable gain control sections 10a-10n, the control signal SC from control terminal 29 is commonly applied. The configuration of these variable gain control sections 10a-10n is the same as that of variable gain control section 10b shown in Fig. 7 or Fig. 12.

To variable current sources 30b-30n, the control signal SC from control terminal 29 is also applied commonly, and the amount of driving current of these variable current sources 30b-30n is adjusted in accordance with the control signal SC (adjusted in accordance with the corresponding control voltage VCR). Specific configuration of these variable current sources 30b-30n is the same as that of variable current source 30 shown in Fig. 7. Variable current sources 30b-30n have their amount of driving current adjusted in accordance with the control voltage for the corresponding variable gain control sections 10b-10n, respectively. Here, variable current sources 30b-30n have their voltage levels adjusted in accordance with the control voltage for the corresponding variable gain control sections, and accordingly, the voltage levels are adjusted in accordance with the control signal SC.

The constant current source 12a arranged for the variable gain control section 10a of the first stage always supplies a constant current.

Therefore, in the configuration of the differential pair control type variable gain amplifier having multistage configuration such as shown in Fig. 13 also, the operating current of the variable gain control sections of the second and following stages are adjusted in accordance with the gain of the corresponding variable gain control sections, using variable current sources 30b-30n, whereby current consumption can be reduced without causing any signal distortion.

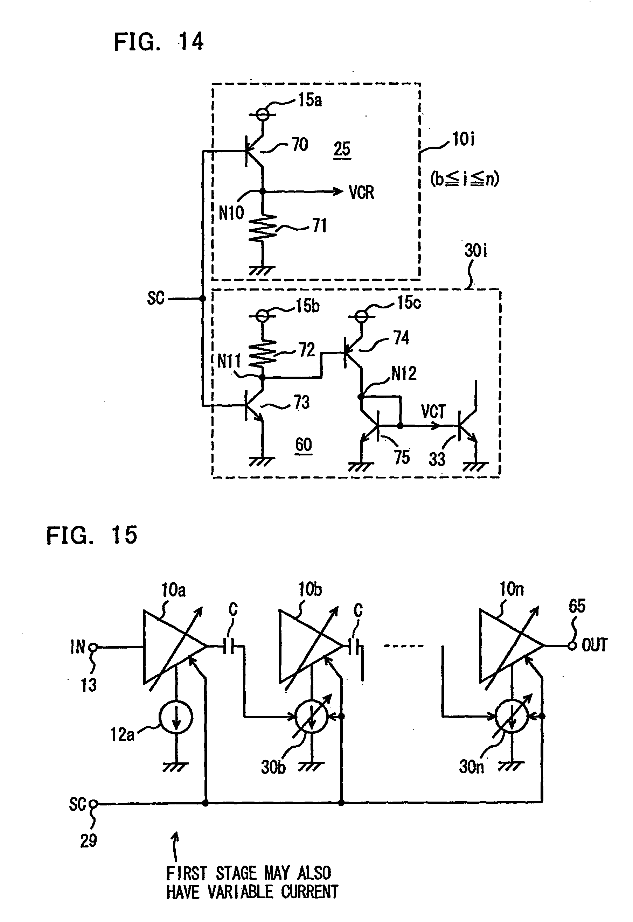

Fig. 14 shows another example of the configuration of variable voltage source 25 in the variable current source 30 (30b-30n) and gain control sections 10b-10n. Fig. 14 shows, as a representative, the configuration of gain control section 10i and variable current source 30i. Here, i is any of b to n.

Referring to Fig. 14, variable voltage source 25 includes a PNP bipolar transistor 70 connected between power supply node 15a and node N10 and receiving at its base the control signal SC, and a resistance element 71 coupled between node N10 and the ground node. At node N10, the control voltage VCR is generated, and applied to the base of a transistor (21) of the differential stage of the corresponding variable gain control section.

In variable current source 30i, current control section 60 includes a resistance element 72 connected between power supply node 15b and a node N11, an NPN bipolar transistor 73 connected between node N11 and the ground node and receiving at its base the control signal SC, a PNP bipolar transistor 74 connected between power supply node 15c and a node N12 and having its base coupled to node N11, and an NPN bipolar transistor 75 coupled between node N12 and ground node and having its base connected to node N12. At base/collector node N12 of NPN bipolar transistor 75, the control voltage VCT is generated. The control voltage VCT is applied to the base of the bipolar transistor 33 of the next stage.

When the control signal SC attains to the high level, the amount of driving current of bipolar transistor 70 lowers in variable voltage source 75, the amount of voltage drop across resistance element 71 lowers accordingly, and voltage level of control voltage VCR lowers.

In current driving section 60, the amount of driving current of bipolar transistor 73 increases, the amount of voltage drop at resistance element 72 increases accordingly, and the voltage level of node N11 lowers. When the voltage level of node N11 lowers, the amount of driving current of bipolar transistor 74 increases, the voltage level of node N12 increases accordingly, and the voltage level of control voltage VCT becomes higher. The bipolar transistor 75 forms a current mirror circuit with bipolar transistor 33 of the next stage, and when the control voltage VCT becomes higher, the amount of driving current of variable current source 30i increases.

When the control signal SC attains to the low level, the amount of driving current of bipolar transistor 70 in variable voltage source 25 increases, the amount of voltage drop across a resistance element 71 increases accordingly, and the voltage level of control voltage VCR increases.

In control voltage generating circuit 32, the amount of driving current of bipolar 73 increases, the amount of voltage drop across resistance element 72 also lowers, and the voltage level of node N11 increases. As the voltage level of node N11 increases, the amount of driving current of bipolar transistor 74 lowers, and the voltage level of node N12 lowers. Accordingly, the amount of driving current of variable current source 30i lowers, along with the decrease in voltage level of control voltage VCT.

Therefore, by utilizing variable current source 30i shown in Fig. 14, it becomes possible to adjust the amount of driving current of the variable current source, in accordance with the control signal SC.

It is noted that the configurations of variable voltage source 25 and control voltage generating circuit 32 may be switched. Circuit configurations of the variable current source and the variable voltage source may be determined dependent on whether the gain is set high or low, when the control signal SC attains to the high level.

[Modification]

Fig. 15 schematically shows a modification of the third embodiment of the present invention. Referring to Fig. 15, between signal input terminal 13 and signal output terminal 65, variable gain control sections 10a-10n are arranged. Between variable gain control sections 10a-10n, capacitance elements C for cutting-off DC components are arranged. For variable gain control section 10a of the first stage, a constant current source 12a is arranged, and for variable gain control sections 10b-10n, variable current sources 30b-30n are arranged, respectively. To these variable current sources 30b-30n, an output signal of the variable gain control section of the preceding stage is applied as in Fig. 12. Therefore, in variable current sources 30b-30n, the current source transistor performs an amplifying operation, in accordance with the output signal of the gain control section of the preceding stage. The gain control sections 10a-10n have their gains controlled in accordance with the control signal SC of control terminal 29, respectively. In variable current sources 30b-30n also, the amount of driving current is adjusted in accordance with the control signal SC or the control voltage in the corresponding gain control sections 10b-10n.

In the configuration of the differential pair control type variable gain amplifier having multistage configuration shown in Fig. 15, by adjusting operating current in accordance with the gain, at the variable gain control sections 10b-10n of the second and following stages, the current consumption can be reduced without impairing linearity of the signal.

In the first to third embodiments, for the gain control section (differential pair transistor) of the first stage, constant current source 12a is arranged. Constant current source 12a for the gain control section of the first stage, however, may also have its driving current adjusted in accordance with the gain of the corresponding variable gain control section, similar to the variable current sources of the next and following stages.

In the first to third embodiments, MOS transistors may be used in place of the bipolar transistors.

As described above, according to the third embodiment of the present invention, in the differential pair control type variable gain amplifier having multistage configuration, the operating current of the gain control section of the second and following stages are adapted to be adjusted in accordance with the gain, and hence the current consumption can be reduced without impairing linearity of the signals.

As described above, according to the present invention, the operating current of the differential stage control type variable gain amplifier is adjusted in accordance with the gain, and the current consumption can be reduced while suppressing signal distortion. Particularly, as the operating current of the second and following amplifying stages is adjusted in accordance with the gain in a differential stage control type variable gain amplifier having multistage configuration, current consumption of amplifying stages with large operating current can be reduced. Thus, a differential stage control type variable amplifier having high gain and low current consumption can be realized.

Although the present invention has been described and illustrated in detail, it is clearly understood that the same is by way of illustration and example only and is not to be taken by way of limitation. Various modifications are possible within the scope of the present invention. The scope of the present invention is limited only by the terms of the appended claims.

Industrial Applicability

The differential pair control type variable gain amplifier in accordance with the present invention is applicable to a wireless communication apparatus. When applied to a portable terminal equipment having communicating function such as a portable telephone, the present invention is particularly effective, as the current consumption is reduced.

**Claims**

1.  A variable gain amplifier, including a first transistor (21) receiving at a control node a gain control signal, and a second transistor (20) forming a differential pair with said first transistor, comprising:

    a differential stage applying a gain based on said gain control signal to an input signal, for generating an output signal; and
    a variable current source circuit (30) coupled to said differential stage, for variably changing driving current of said differential stage in accordance with said gain.

2.  The variable gain amplifier according to claim 1, wherein
    said variable current source circuit (30) makes said driving current small, when the gain of said differential stage is small.

3.  The variable gain amplifier according to claim 1, wherein
    said variable current source circuit (30) includes a current source transistor (Q2) determining said driving current, and a control signal generating circuit (32) generating, from said gain control signal, a current control signal controlling driving current of said current source transistor.

4.  The variable gain amplifier according to claim 3, wherein
    said variable current source circuit (30) includes an input transistor (33) driving a current based on said current control signal, a first current mirror circuit (34) of which driving current is determined by driving current of said input transistor, and an output transistor (Q1) of which driving current is determined by driving current of said first current mirror circuit, forming a second current mirror circuit with said current source transistor (Q2).

5.  The variable gain amplifier according to claim 1, wherein
    said input signal is transmitted to a control node of said second transistor.

6.  The variable gain amplifier according to claim 1, wherein
    said variable current source circuit (30) includes a current source transistor (Q2) determining said driving current, and
    said input signal is transmitted to a control node of said current source transistor.

7.  A variable gain amplifier including a plurality of stages of variable gain amplifying circuits (10a-10n) coupled between an input side (13) to an output side (65) of a signal, wherein
    said variable gain amplifying circuits include
    a differential stage including a first transistor (21) receiving at a control node a gain control signal and, a second transistor (20) forming a differential pair with said first transistor, applying a gain based on said gain control signal to an input signal for generating an output signal, and
    current source circuits (12a), (30b-30n) coupled to said differential stage and determining a driving current of said differential stage; and wherein
    at least one variable gain amplifying circuit of the variable gain amplifying circuit except for the variable gain amplifying circuit of a first stage of said plurality of stages of variable amplifying circuits have driving current of the corresponding current source circuit (30b-30n) varied in accordance with the gain of the variable gain amplifying circuit.

## FIG. 1

## FIG. 2

## FIG. 3

FIG. 4

FIG. 5

FIG. 6

# FIG. 7

EP 1 429 456 A1

FIG. 8

SC >

15

40

N5 → VCR

41

25

FIG. 9

15

42

N6 → VCR

43

25

FIG. 10

VCR —|<  45

15

N7

46

VCT

32

FIG. 11

| 50 | 51 | 52 |
|---|---|---|

VCR → | A/D CONVERTER | → | TABLE MEMORY (ROM) | → | D/A CONVERTER | → VCT

32

FIG. 12

FIG. 13

FIG. 14

FIG. 15

FIRST STAGE MAY ALSO
HAVE VARIABLE CURRENT

**EP 1 429 456 A1**

## INTERNATIONAL SEARCH REPORT

| | International application No. |
|---|---|
| | PCT/JP01/08216 |

| A. CLASSIFICATION OF SUBJECT MATTER |
|---|
| Int.Cl⁷  H03G3/10, H03G3/20 |

According to International Patent Classification (IPC) or to both national classification and IPC

| B. FIELDS SEARCHED |
|---|
| Minimum documentation searched (classification system followed by classification symbols) |
| Int.Cl⁷  H03G3/10, H03G3/20 |

Documentation searched other than minimum documentation to the extent that such documents are included in the fields searched

| Jitsuyo Shinan Koho | 1922-1996 | Toroku Jitsuyo Shinan Koho | 1994-2001 |
|---|---|---|---|
| Kokai Jitsuyo Shinan Koho | 1971-2001 | Jitsuyo Shinan Toroku Koho | 1996-2001 |

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| X<br>Y | JP 8-167241 A (Sony Corporation),<br>25 June, 1996 (25.06.1996),<br>page 3, right column, line 45 to page 4, right column,<br>line 23; Fig. 1   (Family: none) | 1~3<br>4~7 |
| Y | JP 2001-127572 A (Matsushita Electric Ind. Co., Ltd.),<br>11 May, 2001 (11.05.2001),<br>page 4, left column, line 5 to page 5, right column, line<br>30; Figs. 1, 2   (Family: none) | 1~7 |
| Y | JP 2001-177361 A (Sony Corporation),<br>29 June, 2001 (29.06.2001),<br>page 4, left column, line 23 to page 6, left column, line<br>40; Figs. 1 to 3   (Family: none) | 1~7 |
| Y | JP 9-270650 A (Alps Electric Co., Ltd.),<br>14 October, 1997 (14.10.1997),<br>page 4, left column, line 39 to page 5, right column, line<br>21; Figs. 1 to 3<br>& GB 2311670 A       & DE 19713101 A<br>& US 5900781 A1 | 1~7 |

☐ Further documents are listed in the continuation of Box C.     ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 19 December, 2001 (19.12.01) | 15 January, 2002 (15.01.02) |

| Name and mailing address of the ISA/<br>Japanese Patent Office | Authorized officer |
|---|---|
| Facsimile No. | Telephone No. |

Form PCT/ISA/210 (second sheet) (July 1992)